# EUROPEAN PATENT SPECIFICATION

(11) **EP 3 678 204 B1**
(45) Date of publication and mention of the grant of the patent: **19.07.2023**
(21) Application number: 18849887.7
(22) Date of filing: 24.08.2018
(51) Int. Cl.: C23F 1/02, C23C 14/12, C23C 14/04, C23F 1/04

(54) **MASK FOR DEPOSITION OF METALLIC MATERIAL FOR DEPOSITING OLED PIXELS AND MANUFACTURING METHOD THEREOF**
MASKE ZUR ABSCHEIDUNG VON METALLISCHEM MATERIAL ZUR ABSCHEIDUNG VON OLED-PIXELN UND HERSTELLUNGSVERFAHREN DAFÜR
MASQUE DE DÉPÔT DE MATÉRIAU MÉTALLIQUE PERMETTANT LE DÉPÔT DE PIXELS OLED ET PROCÉDÉ DE FABRICATION ASSOCIÉ

(30) Priority: 29.08.2017 KR 20170109724
(43) Date of publication of application: 08.07.2020
(60) Divisional application: 23177768.1
(73) Proprietor: LG Innotek Co., Ltd., Seoul 07796 (KR)
(72) Inventor: KIM, Hae Sik, Seoul 04637 (KR); PAIK, Jee Heum, Seoul 04637 (KR)
(74) Representative: Plasseraud IP
(86) International application number: PCT/KR2018/009813
(87) International publication number: WO 2019/045375

(56) References cited:
- EP-A2- 3 680 949
- WO-A1-2017/142231
- JP-A- 2014 148 745
- KR-A- 20150 056 754
- KR-A- 20160 081 136
- KR-A- 20160 129 639
- KR-A- 20170 075 113

## Description

### [Technical Field]

The invention relates to a deposition mask of a metallic material for depositing an organic light emitting diode (OLED) pixel. Specifically, the deposition mask according to an embodiment is for manufacturing an OLED panel having high-resolution of 500 PPI or more.

### [Background Art]

As a display device having high-resolution and low power consumption is required, various display devices such as a liquid crystal display device and an electroluminescent display device have been developed.

The electroluminescent display device has been spotlighted as a next generation display device due to excellent characteristics such as low light emission, low power consumption, and high-resolution, and the like, as compared with the liquid crystal display device.

There are an organic light emitting display device and an inorganic light emitting display device in an electric field display device. That is, an electric field display device may be classified into the organic light emitting display device and the inorganic light emitting display device according to a material of a light emitting layer.

Of these, the organic light emitting display device has received attention because the organic light emitting display device has a wide viewing angle, has a fast response speed, and is required to have low power consumption.

An organic material constituting such a light emitting layer may be formed to have a pattern for forming a pixel on a substrate by a fine metal mask method.

In this case, the fine metal mask, that is, a mask for deposition may have a through-hole corresponding to the pattern to be formed on the substrate, and, patterns of red (R), green (G), and blue (B) forming a pixel may be formed by depositing the organic material after the fine metal mask is aligned on the substrate.

Recently, various electronic devices such as a virtual reality (VR) device require a display device having ultra-high definition (UHD). Accordingly, a fine metal mask having a fine-sized through-hole capable of forming an ultra-high resolution (UHD-class) pattern is required.

In a metal plate that may be used as a deposition mask, a plurality of through-holes may be formed by an etching process. Such deposition masks are for example known from documents WO 2017/142231 A1 and KR 2016 0129639 A. Z

In this case, when a curvature of a small surface hole in the through-hole and an inclination angle of the small surface hole are smaller than a predetermined range, a deposition material spreads, and thus deposition failure due to overlapping between pixels may occur.

Therefore, a deposition mask having a new structure capable of uniformly forming a high-resolution or ultra-high resolution (UHD-class) pattern of 500 PPI or more without deposition failure.

### [Disclosure]

### [Technical Problem]

An embodiment is directed to providing a deposition mask capable of uniformly forming a pattern with a high-resolution of about 500 PPI or more or an ultra-high resolution (UHD-class) of about 800 PPI or more without deposition failure.

### [Technical Solution]

A deposition mask according to the invention is defined in claims 1 to 11.

In a deposition mask of a metallic material for depositing an OLED pixel according to an embodiment, the deposition mask includes a deposition region for forming a deposition pattern and a non-deposition region other than the deposition region, wherein the deposition region includes a plurality of effective portions spaced apart in a longitudinal direction and an ineffective portion other than the effective portion, wherein the effective portion includes: a plurality of small surface holes formed on one surface; a plurality of large surface holes formed on the other surface opposite to the one surface; a through-hole communicating the small surface hole and the large surface hole; and an island portion between the plurality of through-holes, wherein the deposition mask has a resolution of 500 PPI or more in which a diameter of the through-hole is 33 µm or less and a distance between the through-holes is 48 µm or less, an inclination angle of the small surface hole with respect to the one surface is 70 degrees to 89 degrees, and an inclination curvature radius of the small surface hole with respect to the one surface is 3 µm to 86 µm.

A deposition mask of a metallic material for depositing an OLED pixel according to the invention may be manufactured including: a first step of preparing a base metal plate of a thickness of 20 µm to 30 µm; a second step of disposing a patterned photoresist layer on one side of the base metal plate, forming a groove on one surface of the base metal plate by half-etching an open portion of the photoresist layer, disposing a patterned photoresist layer on the other surface of the base metal plate opposite the one surface, and forming a through-hole connected to the groove on the one surface of the base metal plate by etching the open portion of the photoresist layer; and a third step of removing the photoresist layer to form a deposition mask including a large surface hole formed on the one surface, a small surface hole formed on the other surface opposite to the one surface, and a through-hole formed by a communication portion to which a boundary between the large surface hole and the small surface hole is connected.

### [Advantageous Effects]

The deposition mask is of a metallic material for depositing an OLED pixel having a resolution of 500 PPI or more, and is capable of minimizing deposition failure.

In the deposition mask, a curvature of the small surface hole is 3 µm to 86 µm. According to the invention, an inclination angle between one end of the small surface hole and one end of a communication portion between the small surface and the large surface hole is 70 degrees to 89 degrees. Accordingly, it is possible to minimize spreading of a deposition pattern deposited through the deposition mask according to the invention. Therefore, the deposition mask according to the invention may prevent deposition failure due to a shadow effect of two adjacent deposition patterns among R, G, and B patterns while maintaining ultra-high resolution.

In addition, it is possible to improve process efficiency of an organic light emitting display device by preventing an organic material from being de-filmed during a deposition process.

### [Description of Drawings]

FIGS. 1 to 3 are conceptual diagrams describing a process of depositing an organic material on a substrate using a deposition mask according to the invention.
FIG. 4 is a view illustrating a plan view of a deposition mask according to the invention.
FIG. 5 is a view illustrating a plan view of an effective portion of a deposition mask.
FIG. 6 is a view in which a cross-sectional view taken along line A-A' and a cross-sectional view taken along line B-B' are overlapped in FIG. 5.
FIG. 7 is a view illustrating another plan view of deposition mask according to the invention.
FIG. 8 is a cross-sectional view taken along line B-B' in FIG. 5A of a deposition mask according to the invention.
FIG. 9 is a cross-sectional view in the same direction as FIG. 8 of a deposition mask according to Comparative Example.
FIG. 10 is views illustrating a manufacturing process of a deposition mask according to Example.
FIG. 11 is views illustrating a manufacturing process of a deposition mask according to Comparative Example.
FIG. 12 and FIG. 13 are views showing a deposition pattern formed through a deposition mask according to Example.
FIG. 14 and FIG. 15 are views showing a deposition pattern formed through a deposition mask according to Comparative Example.

### [Modes of the Invention]

Hereinafter, embodiments will be described in detail with reference to the accompanying drawings. However, the scope of the present invention is not limited to a part of the embodiments described, and may be implemented in various other forms, and within the scope of the present invention, one or more of the elements of the embodiments may be selectively combined and replaced.

In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

Further, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Furthermore, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

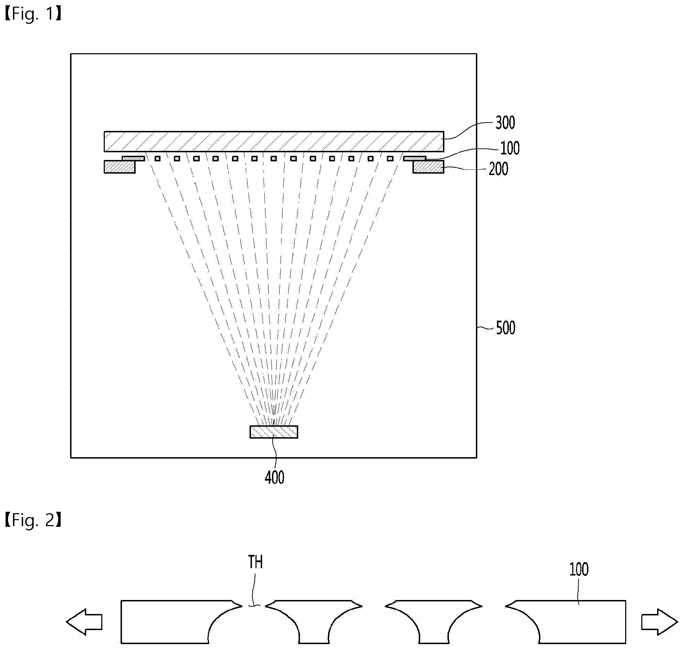

A process of depositing an organic material on a substrate using a deposition mask according to the invention will be described with reference to FIGS. 1 to 3.

FIG. 1 is a perspective view showing an organic material deposition device including a deposition mask 100 according to the invention.

The organic material deposition apparatus may include a deposition mask 100, a mask frame 200, a substrate 300, an organic material deposition container 400, and a vacuum chamber 500.

The deposition mask 100 includes a plurality of through-holes TH at an effective portion for deposition. The deposition mask 100 may be a substrate for deposition mask including a plurality of through-holes TH. At this point, the through-holes may be formed to correspond to patterns to be formed on the substrate. The deposition mask 100 may include an ineffective portion other than the effective portion including a deposition region.

The mask frame 200 may include an opening 205. The plurality of through-holes of the deposition mask 100 may be disposed on a region corresponding to the opening 205. Accordingly, organic material supplied to the organic material deposition container 400 may be deposited on the substrate 300. The deposition mask may be disposed and fixed on the mask frame 200. For example, the deposition mask may be pulled and fixed on the mask frame 200 by welding.

Referring to FIGS. 1 and 2, the deposition mask 100 may be pulled in opposite directions at an end disposed on the outermost portion of the deposition mask 100. In the deposition mask 100, one end of the deposition mask 100 and the other end opposite to the one end may be pulled in opposite directions in a longitudinal direction of the deposition mask 100. The one end and the other end of the deposition mask 100 may face each other and be disposed in parallel. The one end of the deposition mask 100 may be one of end portions forming four side surfaces disposed on the outermost portion of the deposition mask 100. For example, the deposition mask 100 may be pulled at a tensile force of 0.4 kgf to 1.5 kgf. Accordingly, the pulled deposition mask 100 may be set on the mask frame 200.

Then, the deposition mask 100 may be fixed to the mask frame 200 by welding the ineffective portion of the deposition mask 100. Subsequently, a portion of the deposition mask 100 disposed outside the mask frame 200 may be removed by a method such as cutting.

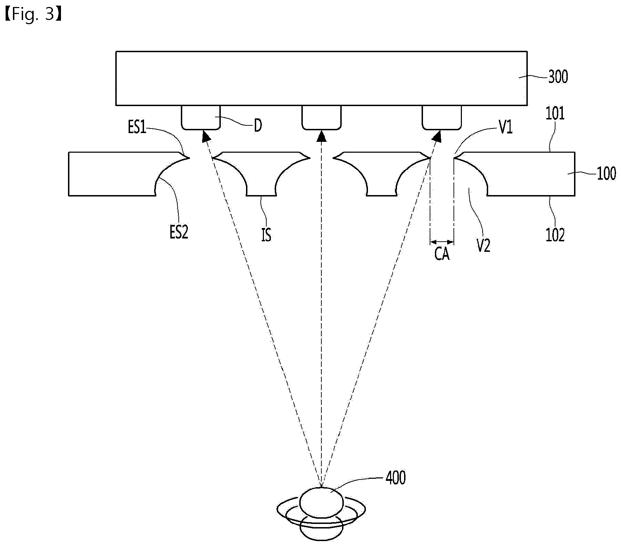

Referring to FIG. 1 and FIG. 3, the substrate 300 may be a substrate used for manufacturing a display device. Patterns of red (R), green (G), and blue (B) may be formed on the substrate 300 to form a pixel that is three primary colors of light.

The organic material deposition container 400 may be a crucible. An organic material may be disposed at an inside of the crucible.

As a heat source and/or current is supplied to the crucible in the vacuum chamber 500, the organic material may be deposited on the substrate 100.

FIG. 3 is a view illustrating that a plurality of deposition patterns are formed on the substrate 300 through a plurality of through-holes of the deposition mask 100.

The deposition mask 100 includes a first surface 101 and a second surface 102 facing the first surface.

The first surface 101 of the deposition mask 100 includes a small surface hole V1, and the second surface 102 of the deposition mask 100 includes a large surface hole V2. The through-hole is communicated by a communication portion CAto which the boundary of the small surface hole V1 and the large surface hole V2 is connected.

The deposition mask 100 may include a first etching surface ES1 in the small surface hole V1. The deposition mask 100 may include a second etching surface ES2 in the large surface hole V2. The through-hole may be formed by communicating the first etching surface ES1 in the small surface hole V1 and the second etching surface ES2 in the large surface hole V2. For example, the first etching surface ES1 in one small surface hole V1 may communicate with the second etching surface ES2 in one large surface hole V2 to form one through-hole.

A width of the large surface hole V2 is greater than that of the small surface hole V1. At this time, the width of the small surface hole V1 is measured at the first surface 101, and the width of the large surface hole V2 is measured at the second surface 102.

The small surface hole V1 may be disposed toward the substrate 300. The small surface hole V1 may be disposed close to the substrate 300. Accordingly, the small surface hole V1 may have a shape corresponding to a deposition material, that is, a deposition pattern DP.

The large surface hole V2 may be disposed toward the organic material deposition container 400. Accordingly, the large surface hole V2 may accommodate the organic material supplied from the organic material deposition container 400 in a wide width, and a fine pattern may be formed quickly on the substrate 300 through the small surface hole V1 having a width smaller than that of the large surface hole V2.

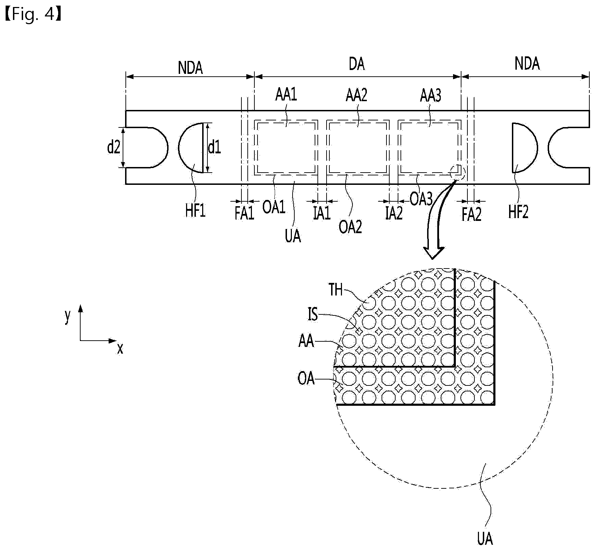

FIG. 4 is a view illustrating a plan view of a deposition mask according to the invention. Referring to FIG. 4, the deposition mask according to the invention may include a deposition region DA and a non-deposition region NDA.

The deposition region DA may be a region for forming a deposition pattern. One deposition mask may include a plurality of deposition regions DA. For example, the deposition region DA of an embodiment may include a plurality of effective portions AA1, AA2, and AA3 capable of forming a plurality of deposition patterns.

The plurality of effective portions may include a first effective portion AA1, a second effective portion AA2, and a third effective portion AA3. One deposition region DA may be any one of the first effective portion AA1, the second effective portion AA2, and the third effective portion AA3.

In case of a small-sized display device such as a smartphone, an effective portion of any one of a plurality of deposition regions included in the deposition mask may be one for forming one display device. Accordingly, one deposition mask may include a plurality of effective portions to form a plurality of display devices at the same time. Therefore, the deposition mask according to the invention may improve process efficiency.

Alternatively, in case of a large-sized display device such as a television, a plurality of effective portions included in one deposition mask may be a part for forming one display device. In this case, the plurality of effective portions may be for preventing deformation due to a load of the mask.

The deposition region DA may include a plurality of isolation regions IA1 and IA2 included in one deposition mask. The isolation regions IA1 and IA2 may be disposed between adjacent effective portions. The isolation regions IA1 and IA2 may be spaced regions between the plurality of effective portions. For example, a first isolation region IA1 may be disposed between the first effective portion AA1 and the second effective portion AA2. For example, a second isolation region IA2 may be disposed between the second effective portion AA2 and the third effective portion AA3. The isolation region may distinguish adjacent effective regions, and the plurality of effective portions may be supported by one deposition mask.

The deposition mask may include a non-deposition region NDA on both side portions in a longitudinal direction of the deposition region DA. The deposition mask according to the invention may include the non-deposition region NDA on both sides in a horizontal direction of the deposition region DA.

The non-deposition region NDA of the deposition mask may be a region not involved in a deposition. The non-deposition region NDA may include frame fixing regions FA1 and FA2 for fixing the deposition mask to a mask frame. For example, the non-deposition region NDA of the deposition mask may include a first frame fixing region FA1 on one side of the deposition region DA, and may include a second frame fixing region FA2 on the other side opposite to the one side of the deposition region DA. The first frame fixing region FA1 and the second frame fixing region FA2 may be region s fixed to the mask frame by welding.

The non-deposition region NDA may include half-etching portions HF1 and HF2. For example, the non-deposition region NDA of the deposition mask may include a first half-etching portion HF1 on one side of the deposition region DA, and may include a second half-etching portion HF2 on the other side opposite to the one side of the deposition region DA. The first half-etching portion HF1 and the second half-etching portion HF2 may be regions in which grooves are formed in a depth direction of the deposition mask. The first half-etching portion HF1 and the second half-etching portion HF2 may have a groove having a thickness of about 1/2 of the deposition mask, thereby dispersing stress when the deposition mask is pulled.

The half-etching portion may be simultaneously formed when forming a small surface hole or a large surface hole. Accordingly, it is possible to improve process efficiency.

Surface treatment layer different from a material of a metal plate may be formed in the deposition region DA of the deposition mask, and the surface treatment layer may not be formed in the non-deposition region NDA. Alternatively, the surface treatment layer different from the material of the metal plate may be formed on only one surface or the other surface opposite to the one surface of the deposition mask. Alternatively, the surface treatment layer different from the material of the metal plate may be formed only on a portion of one surface of the deposition mask. For example, one surface and/or the other surface of the deposition mask, and the entire and/or a portion of the deposition mask may include surface treatment layer having a lower etch rate than that of the material of the metal plate, thereby improving an etching factor. Accordingly, the deposition mask of the invention may form a through-hole having a fine size with high efficiency. As an example, the deposition mask of the invention may form a deposition pattern having a high-resolution of 500 PPI or more with high efficiency. Here, the surface treatment layer may include a material different from the material of the metal plate, or may include a metal material having a different composition of the same element.

The half-etching portion may be formed in an ineffective portion UA of the deposition region DA. The half-etching portion may be dispersed in the entire or a part of the ineffective portion UA to be disposed in plural in order to disperse a stress when the deposition mask is pulled.

In addition, the half-etching portion may be formed in the frame fixing region and/or a peripheral region of the frame fixing region. Accordingly, a stress of the deposition mask generated when fixing the deposition mask to the mask frame, and/or depositing a deposition material after fixing the deposition mask to the mask frame may be uniformly dispersed. Accordingly, the deposition mask may be maintained so as to have a uniform through-hole.

The frame fixing regions FA1 and FA2 for fixing to the mask frame of the non-deposition region NDA may be disposed between the half-etching portions HF1 and HF2 of the non-deposition region NDA and an effective portion of the deposition region DA adjacent to the half-etching portions HF1 and HF2. For example, the first frame fixing region FA1 may be disposed between the first half-etching portion HF1 of the non-deposition region NDA and the first effective portion AA1 of the deposition region DA adjacent to the first half-etching portion HF1. For example, the second frame fixing region FA2 may be disposed between the second half-etching portion HF2 of the non-deposition region NDA and the third effective portions AA3 of the deposition region DA adjacent to the second half-etching portion HF2. Accordingly, it is possible to simultaneously fix a plurality of deposition pattern portions.

The deposition mask may include a semicircular shaped open portion at both ends in a horizontal direction X. The non-deposition region NDA of the deposition mask may include one semicircular shaped open portion at each of both ends in the horizontal direction. For example, the non-deposition region NDA of the deposition mask may include an open portion of which a center in a vertical direction Y is opened on one side in the horizontal direction. For example, the non-deposition region NDA of the deposition mask may include the open portion of which the center in the vertical direction is opened on the other side opposite to the one side in the horizontal direction. That is, both ends of the deposition mask may include the open portion at 1/2 point of a length in the vertical direction. For example, both ends of the deposition mask may be shaped like a horseshoe.

The half-etching portion included in the deposition mask of the invention may be formed in various shapes. The half-etching portion may include a semi-circular shaped groove portion. The groove may be formed on at least one of one surface of the deposition mask and the other surface opposite to the one surface. Preferably, the half-etching portion may be formed on a surface corresponding to the small surface hole (a surface side to be deposited). Accordingly, the half-etching portion may be formed at the same time with the small surface hole, thereby improving process efficiency. In addition, the half-etching portion may disperse a stress that may be generated due to a difference in size between large surface holes.

Alternatively, the half-etching portion may be formed on both sides of the deposition mask in order to disperse the stress of the deposition mask. In this case, a half-etching region of the half-etching portion may be wider in a plane corresponding to a first surface hole (a surface side to be deposited). That is, the deposition mask according to the invention may include the half-etching portion as grooves are formed on first and second surfaces of the deposition mask, respectively. In detail, a depth of the groove of the half-etching portion formed on the first surface may be greater than that of the groove of the half-etching portion formed on the second surface. Accordingly, the half-etching portion may disperse a stress that may occur due to a difference in a size between the small surface hole and the large surface hole. Formation of the small surface hole, the large surface hole, and the half-etching portion may make surface areas on the first and second surfaces of the deposition mask similar to each other, thereby preventing displacement of the through-holes.

In addition, the grooves formed on the first surface and the second surface may be formed so as to be displaced from each other. Accordingly, the half-etching portion may not be passed through.

The half-etching portion may include a curved surface and a flat surface. The flat surface of the first half-etching portion HF1 may be disposed to be adjacent to the first effective region AA1, and the flat surface may be disposed horizontally with an end in a longitudinal direction of the deposition mask. The curved surface of the first half-etching portion HF1 may have a convex shape toward one end in the longitudinal direction of the deposition mask. For example, the curved surface of the first half-etching portion HF1 may be formed such that a 1/2 point of a length in a vertical direction of the deposition mask corresponds to the radius of a semicircular shape.

The flat surface of the second half-etching portion HF2 may be disposed to be adjacent to the third effective region AA3, and the flat surface may be disposed horizontally with an end in a longitudinal direction of the deposition mask. The curved surface of the second half-etching portion HF2 may have a convex shape toward the other end in the longitudinal direction of the deposition mask. For example, the curved surface of the second half-etching portion HF2 may be formed such that a 1/2 point of a length in a vertical direction of the deposition mask corresponds to the radius of a semicircular shape.

Meanwhile, a curved surface of the open portion positioned at the both ends of the deposition mask may be directed to the half-etching portion. Accordingly, the open portions at the both ends of the deposition mask may have the shortest separation distance at 1/2 point of a length in the vertical direction of the first or second half-etching portion and the deposition mask. quadrangular shape

Although not shown in the drawings, the half-etching portion may have a quadrangular shape. The first half-etching portion HF1 and the second half-etching portion HF2 may have a rectangular or square shape.

The deposition mask according to the invention may include a plurality of half-etching portions. The deposition mask according to the invention may include a plurality of half-etching portions in at least one of the deposition region DA and the non-deposition region NDA. The deposition mask according to the invention may include the half-etching portion only in the ineffective portion UA. The ineffective portion UA may be a region other than the effective portion AA.

The deposition mask according to the invention may include two half-etching portions. Although not shown in the drawings, the deposition mask according to the invention may include four half-etching portions. For example, the half-etching portion may include an even number of half-etching portions, thereby efficiently dispersing a stress. The deposition mask according to the invention may be disposed only in the non-deposition region NDA.

It is preferable to form the half-etching portion to be symmetric in an X-axis direction or in a Y-axis direction with respect to a center of the mask. Through the same, it is possible to equalize a tensile force in both directions.

A length d1 in a vertical direction of the first half-etching portion HF1 or the second half-etching portion HF2 may correspond to a length d2 in a vertical direction of the open portion. Accordingly, when the deposition mask is pulled, a stress may be uniformly dispersed, so that the deformation (wave deformation) of the deposition mask may be reduced. Therefore, the deposition mask according to the invention may have a uniform through-hole, so that the deposition efficiency of the pattern may be improved. Preferably, the length d1 in the vertical direction the first half-etching portion HF1 or the second half-etching portion HF2 may be about 80% to 200% of the length d2 in the vertical direction of the open portion (d1:d2 = 0.8 to 2:1). The length d1 in the vertical direction of the first half-etching portion HF1 or the second half-etching portion HF2 may be about 90% to about 150% of the length d2 in the vertical direction of the open portion (d1:d2 = 0.9 to 1.5:1). The length d1 in the vertical direction of the first half-etching portion HF1 or the second half-etching portion HF2 may be about 95% to about 110% of the length d2 in the vertical direction of the open portion (d1:d2 = 0.95 to 1.1:1).

The deposition mask may include a plurality of effective portions AA1, AA2, and AA3 spaced in the longitudinal direction and an ineffective portion UA other than the effective portion.

The effective portions AA1, AA2, and AA3 of the deposition mask may include a plurality of through-holes TH and an island portion IS supporting between the plurality of through-holes TH. The island portion IS may refer to a portion which is not etched in one surface or the other surface of the effective portion of the deposition mask. In detail, the island portion IS may be a non-etched region between the through-hole and the through-hole on the other surface on which the large surface hole of the effective portion of the deposition mask is formed. Therefore, the island portion IS may be disposed in parallel with one surface of the deposition mask.

The island portion IS may be disposed coplanar with the other surface of the deposition mask. Accordingly, the island portion IS may have the same thickness as at least a portion of the ineffective portion on the other surface of the deposition mask. In detail, the island portion IS may have the same thickness as a non-etched portion of the ineffective portion on the other surface of the deposition mask. Accordingly, deposition uniformity of a sub-pixel may be improved through the deposition mask.

Alternatively, the island portion IS may be disposed in a flat surface parallel to the other surface of the deposition mask. Here, the parallel flat surface may include that a step in height of the other surface of the deposition mask in which the island portion IS is disposed and the other surface of the non-etched deposition mask of the ineffective portions is ± 1 µm or less by an etching process around the island portion IS.

The island portion IS may be positioned between adjacent through-holes among the plurality of through-holes. That is, a region other than the through-hole may be an island portion IS in the effective portions AA1, AA2, and AA3 of the deposition mask 100.

The effective portions AA1, AA2, and AA3 may include a plurality of small surface holes V1 formed on one surface of the deposition mask 100, a plurality of large surface holes V2 formed on the other surface opposite to the one surface, and a through-hole TH formed by a communication portion CA in which a boundary between the small surface hole and the large surface hole is connected.

The deposition mask100 may include an ineffective portion UA disposed at an outer periphery of the effective region.

The effective portion AA may be an inner region when an outer periphery of through-holes positioned at the outermost portion for depositing an organic material among a plurality of through-holes is connected. The ineffective portion UA may be an outer region when the outer periphery of the through-holes positioned at the outermost portion for depositing the organic material among the plurality of through-holes is connected.

The ineffective portion UA is a region excluding the effective region of the deposition region DA and the non-deposition region NDA. The ineffective portion UA may include outer regions OA1, OA2, and OA3 surrounding an outer periphery of the effective portions AA1, AA2, and AA3.

The deposition mask according to the invention may include a plurality of outer regions OA1, OA2, and OA3. The number of the outer regions may correspond to the number of the effective portions. That is, one effective portion may include one outer region spaced apart at a predetermined distance in the horizontal direction and the vertical direction from an end of one effective portion.

The first effective portion AA1 may be included in a first outer region OA1. The first effective portion AA1 may include a plurality of through-holes for forming a deposition material. The first outer region OA1 surrounding the outer periphery of the first effective portion AA1 may include a plurality of through-holes.

A shape of the through-hole TH of the first effective portion AA1 may correspond to a shape of the through-hole of the first outer region OA1. Accordingly, uniformity of the through-hole included in the first effective portion AA1 may be improved. For example, the shape of the through-hole TH of the first effective portion AA1 and the shape of the through-hole of the first outer region OA1 may be in a circular shape. However, the embodiment is not limited thereto, and the through-hole may have various shapes such as a diamond pattern, an oval pattern, and the like.

The plurality of through-holes included in the first outer region OA1 is for reducing etching failure of the through-holes positioned at the outermost portion of the effective portion. Accordingly, the deposition mask according to the invention may improve the uniformity of the plurality of through-holes positioned in the effective portion, and may improve the quality of the deposition pattern produced through the same.

The through-hole included in the effective portion may have a shape partially corresponding to that of the through-hole included in the ineffective portion. As an example, the through-hole included in the effective portion may have a different shape from that of a through-hole positioned at an edge portion of the ineffective portion. Accordingly, it is possible to adjust a difference in stress according to a position of the deposition mask.

The second effective portion AA2 may be included in the second outer region OA2. The second effective portion AA2 may have a shape corresponding to the first effective portion AA1. The second outer region OA2 may have a shape corresponding to the first outer region OA1.

The second outer region OA2 may further include two through-holes in the horizontal direction and the vertical direction, respectively, from the through-hole positioned at the outermost portion of the second effective portion AA2. For example, in the second outer region OA2, two through-holes may be disposed in a row in the horizontal direction at an upper and a lower portion of the through-hole positioned at the outermost portion of the second effective portion AA2, respectively. For example, in the second outer region OA2, two through-holes may be disposed in a line in the vertical direction at the left side and the right side of the through-hole positioned at the outermost portion of the second effective portion AA2, respectively. The plurality of through-holes included in the second outer region OA2 is for reducing etching failure of the through-holes positioned at the outermost portion of the effective portion. Accordingly, the deposition mask according to the invention may improve the uniformity of the plurality of through-holes positioned in the effective portion, and may improve the quality of the deposition pattern manufactured through the same.

The third effective portion AA3 may be included in the third outer region OA3. The third effective portion AA3 may include a plurality of through-holes for forming a deposition material. The third outer region OA3 surrounding the outer periphery of the third effective portion AA3 may include a plurality of through-holes.

The third effective portion AA3 may be in a shape corresponding to that of the first effective portion AA1. The third outer region OA3 may be in a shape corresponding to that of the first outer region OA1.

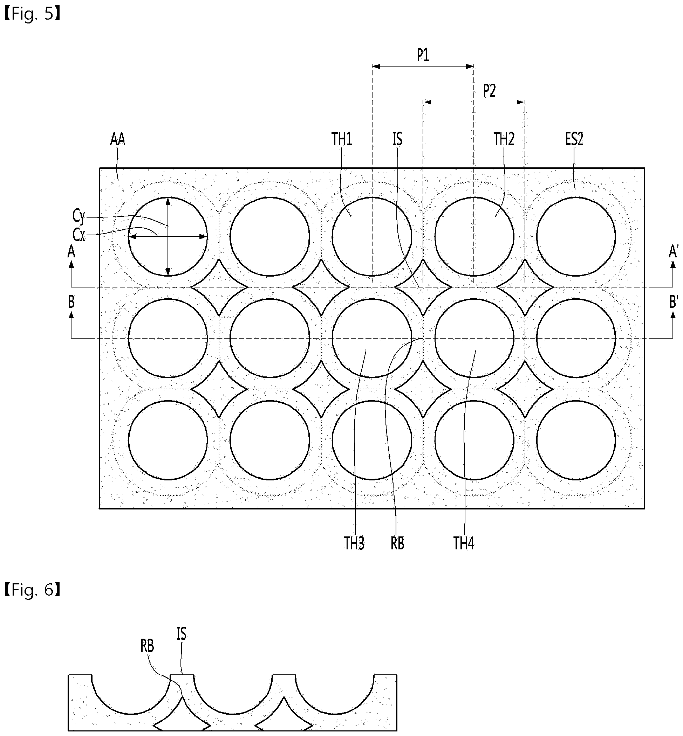

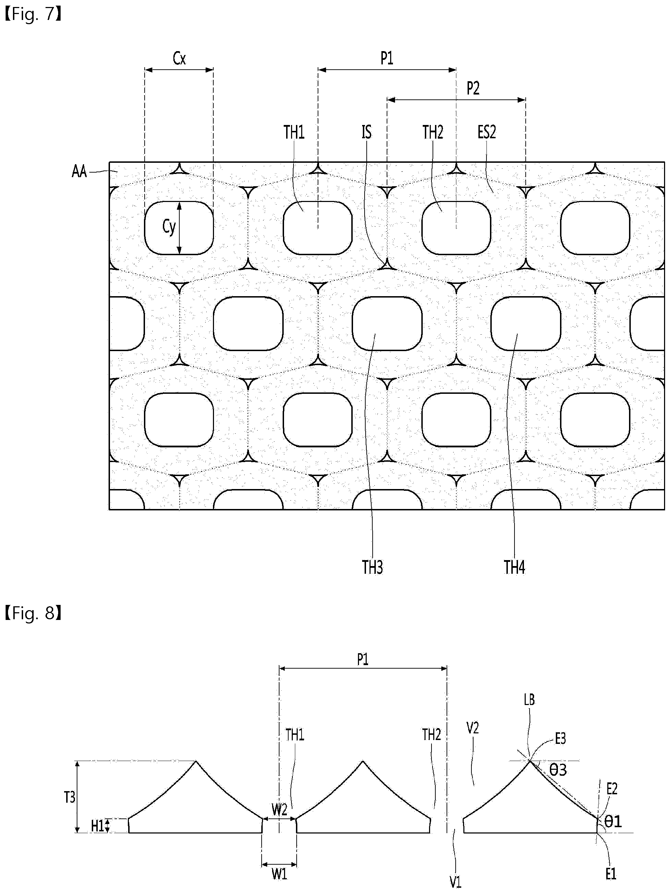

FIG. 5 and FIG. 7 are views and photographs showing a plan view of an effective portion of a deposition mask. FIG. 5 and FIG. 7 are plan views or photographs of an effective portion of any one of the first effective portion AA1, the second effective portion AA2, and the third effective portion AA3. FIG. 5A and FIG. 6 are views for describing a shape of through-holes and arrangement between the through-holes, and of course, the deposition mask according to the invention is not limited to a number of the through-holes in the drawings.

Referring to FIG. 5, the deposition mask 100 may include a plurality of through-holes. The plurality of through-holes may have a circular shape. Accordingly, a diameter Cx in the horizontal direction and a diameter Cy in the vertical direction of the through-hole may correspond to each other.

Alternatively, referring to FIG. 7, the through-hole may have an elliptical shape. Accordingly, the diameter Cx in the horizontal direction of the through-hole and the diameter Cy in the vertical direction may be different from each other. For example, the diameter Cx in the horizontal direction of the through-hole may be larger than the diameter Cy in the vertical direction. However, the invention is not limited thereto, and of course, the through-hole may have a rectangular shape, an octagonal shape, or a rounded octagonal shape.

As an example, in the case of measuring a diameter Cx in the horizontal direction and a diameter Cy in the vertical direction of a reference hole which is any one of through-holes, a deviation between the diameters Cx in the horizontal direction and a deviation between the diameters Cy in the vertical direction of each of holes adjacent to the reference hole may be realized as 2% to 10%.

That is, when a size deviation between the adjacent holes of one reference hole is realized as 2% to 10%, deposition uniformity may be secured. The size deviation between the reference hole and the adjacent holes may be 4% to 9%. For example, the size deviation between the reference hole and the adjacent holes may be 5% to 7%. For example, the size deviation between the reference hole and the adjacent holes may be 2% to 5%. When the size deviation between the reference hole and the adjacent holes is less than 2%, an occurrence ratio of moire in an OLED panel after deposition may be increased. When the size deviation between the reference hole and the adjacent holes is more than 10%, an occurrence ratio of color unevenness in the OLED panel after deposition may be increased. An average deviation of the diameters of the through-holes may be ± 5 µm. For example, the average deviation of the diameters of the through-holes may be ± 3 µm. For example, the average deviation of the diameters of the through-holes may be ± 1 µm. In the embodiment, deposition efficiency may be improved by realizing the size deviation between the reference hole and the adjacent holes within ± 3 µm.

The through-holes may be disposed in a row or may be disposed crossing each other according to a direction. Referring to FIG. 5, the through-holes may be disposed in a row in a vertical axis, and may be disposed in a row in a horizontal axis.

A first through-hole TH1 and a second through-hole TH2 may be disposed in a row in the horizontal axis. In addition, the third through-hole TH1 and the fourth through-hole TH4 may be disposed in a row in the horizontal axis.

The first through-hole TH1 and the third through-hole TH3 may be disposed in a row in the vertical axis. In addition, the second through-holes TH2 and the fourth through-holes TH4 may be disposed in a row in the horizontal axis.

When the through-holes are disposed in a row in the vertical axis and the horizontal axis, an island portion is placed between two through-holes that are adjacent to each other in the diagonal direction, in which both the vertical axis and the horizontal axis intersect. That is, the island portion may be position between two adjacent through-holes that are positioned in the diagonal direction to each other.

An island portion IS may be disposed between the first through-hole TH1 and the fourth through-hole TH4. Further, the island portion IS may be disposed between the second through-hole TH2 and the third through-hole TH3. The Island portion IS may be disposed in an inclination angle direction of about +45 degrees and an inclination angle direction of about -45 degrees with respect to the horizontal axis crossing two adjacent through-holes, respectively. Here, an inclination angle direction of about ± 45 may refer to a diagonal direction between the horizontal axis and the vertical axis, and the diagonal inclination angle is measured on the same plane of the horizontal axis and the vertical axis.

Referring to FIG. 7, the through-holes are disposed in a row on any one of the vertical axis or the horizontal axis, and may be disposed to cross each other on one axis.

The first through-hole TH1 and the second through-hole TH2 may be disposed in a row on the horizontal axis. The third through-hole TH1 and the fourth through-hole TH4 may be disposed to cross the first through-hole TH1 and the second through-hole TH2 on the vertical axis, respectively.

When the through-holes are disposed in a row in any one direction of the vertical axis and the horizontal axis, and cross in the other direction, the island portion may be positioned between two adjacent through-holes in the other direction of the vertical axis and the horizontal axis. Alternatively, the island portion may be positioned between three through-holes adjacent to each other. Two through-holes of the three adjacent through-holes are through-holes disposed in a row, and the remaining one through-hole may refer to a through-hole that may be disposed in a region between the two through-holes at an adjacent position in a direction corresponding to the direction of the row. The island portion IS may be disposed between the first through-hole TH1, the second through-hole TH2, and the third through-hole TH3. Alternatively, the island portion IS may be disposed between the second through-hole TH2, the third through-hole TH3, and the fourth through-hole TH4.

The island portion IS of FIG. 5 and FIG.7 may refer to a non-etched surface between the through-holes in the other surface of the deposition mask in which the large surface hole of the effective portion AA is formed. In detail, the island portion IS may be the other surface of the non-etched deposition mask except the second etching surface ES2 and the through-hole TH positioned in the large surface hole in the effective portion AA of the deposition mask. The deposition mask of the invention may be for deposition of OLED pixels of high-resolution to ultra-high resolution having a resolution of 500 PPI to 800 PPI or more.

For example, the deposition mask of the invention may be for forming a deposition pattern having high-resolution of quad high definition (QHD) having a resolution of 500 PPI or more. For example, the deposition mask of the invention may be for deposition of OLED pixels having a pixel number of 2560*1440 or more in the horizontal direction and the vertical direction, and a resolution of 530 PPI or more. According to the deposition mask of the invention, a number of pixels per inch may be 530 PPI or more based on a 5.5-inch OLED panel. That is, one effective portion included in the deposition mask of the invention may be for forming a pixel number with a resolution of 2560 * 1440 or more.

For example, the deposition mask of the invention may be for forming a deposition pattern having ultra-high resolution of ultra-high definition (UHD) having a resolution of 700 PPI or more. For example, the deposition mask of the invention may be for forming a deposition pattern having UHD-class resolution for the deposition of OLED pixels having a pixel number of 3840*2160 or more in the horizontal direction and the vertical direction and a resolution of 794 PPI.

A diameter of one through-hole may be a width between the communication portions CA. In detail, the diameter of the one through-hole may be measured at the point in which an end of the inner side surface in the small surface hole meets an end of the inner side surface in the large surface hole. A measuring direction of the diameter of the through-hole may be any one of a horizontal direction, a vertical direction, and a diagonal direction. The diameter of the through-hole measured in the horizontal direction is 33 µm or less. Alternatively, the diameter of the through-hole may be an average value of values measured in the horizontal direction, the vertical direction, and the diagonal direction, respectively.

Accordingly, the deposition mask according to the invention may implement a QHD-class resolution.

For example, the diameter of the through-hole in the horizontal direction may be 20 µm or less. Accordingly, the deposition mask according to the invention may implement a UHD-class resolution.

For example, the diameter of the through-hole may be 15 µm to 33 µm. For example, the diameter of the through-hole may be 19 µm to 33 µm. For example, the diameter of the through-hole may be 20 µm to 17 µm. When the diameter of the through-hole exceeds 33 µm, it may be difficult to implement a resolution of 500 PPI or more. On the other hand, when the diameter of the through-hole is less than 15 µm, deposition failure may occur.

The diameter of the through-hole may be measured based on a green (G) pattern. This is because since the G pattern among R, G, and B patterns has a low recognition rate through vision, a larger number is required than the R and B patterns, and a pitch between the through-holes may be narrower than the R and B patterns.

The measuring direction of the diameter of the through-hole and the measuring direction of a pitch between two through-holes may be the same. The pitch of the through-holes may be a value of measuring a pitch between two adjacent through-holes in the horizontal direction or the vertical direction.

Referring to FIG. 5, a pitch between two adjacent through-holes among the plurality of through-holes in the horizontal direction is 48 µm or less. For example, the pitch between two adjacent through-holes among the plurality of through-holes in the horizontal direction may be 20 µm to 48 µm. For example, the pitch between two adjacent through-holes among the plurality of through-holes in the horizontal direction may be 30 µm to 35 µm.

Here, the pitch may refer to a pitch P1 between a center of a first through-hole TH1 and a center of a second through-hole TH2, which are adjacent in the horizontal direction.

Alternatively, here, the pitch may refer to a pitch P2 between a center of a first island portion and a center of a second island portion, which are adjacent in the horizontal direction. Here, the center of the island portion may be a center at the non-etched other surface between four adjacent through-holes in the horizontal direction and the vertical direction. For example, the center of the island portion, based on the first through-hole TH1 and the second through-hole TH2 which are adjacent in the horizontal direction, may refer to a point at which the horizontal axis and the vertical axis connecting the edges of one island portion IS positioned in a region between the third through-hole TH3 vertically adjacent to the first through-hole TH1 and the fourth through-hole TH4 vertically adjacent to the second through-hole TH2 intersect.

Alternatively, the pitch may refer to a pitch P2 between a center of the first island portion and a center of the second island portion adjacent to the first island portion, among three adjacent through-holes in the horizontal direction.

Referring to FIG. 7, a pitch may refer to a pitch P2 between a center of a first island portion and a center of a second island portion which are adjacent in the horizontal direction. Here, the center of the island portion may be a center at a non-etched other surface between one through-hole and two adjacent through-holes in the vertical direction. Alternatively, here, the center of the island portion may be a center at the non-etched other surface between two through-holes and one through-hole adjacent in the vertical direction. That is, the center of the island portion is a center of the non-etched surface between three adjacent through-holes, and the three adjacent through-holes may refer that a triangular shape may be formed when the centers are connected.

For example, the center of the island portion may be a center at the other surface that is not etched between the third through-holes TH3 at least partially or entirely positioned in regions between the vertical directions of each of a first through-hole TH1 and a second through-hole TH2 adjacent to each other in the horizontal direction, and the first through-hole TH1 and the second through-hole TH2.

In the deposition mask according to the invention the diameter of the through-hole is 33 µm or less, and the pitch between the through-holes is 48 µm or less, and thus OLED pixels having a resolution of 500 PPI or more may be deposited. That is, QHD-class resolution may be implemented using the deposition mask according to the invention.

The diameter of the through-hole and the pitch between the through-holes may be a size for forming a green sub pixel. The deposition mask may be an OLED deposition mask for realizing quad high display pixels.

For example, the deposition mask may be for depositing at least one subpixel among red R, first green G1, blue B, and second green G2. In detail, the deposition mask may be for depositing a red R subpixel. Alternatively, the deposition mask may be for depositing a blue B subpixel. Alternatively, the deposition mask may be for simultaneously forming a first green G1 subpixel and a second green G2 subpixel.

The pixel arrangement of an organic light emitting display device may be disposed in an order of "red R-first green G1-blue B-second green G2". In this case, red R-first green G1 may form one pixel RG, and blue B-second green G2 may form another pixel BG. In the organic light emitting display device having such an arrangement, since a deposition interval of a green light emitting organic material is narrower than that of a red light emitting organic material and a blue light emitting organic material, a form of deposition mask like the present invention may be required.

In the deposition mask according to the invention, the diameter of the through-holes is 20 µm or less, and the pitch between the through-holes is 32 µm or less, and thus OLED pixels having a resolution of 800 PPI class may be deposited. That is, UHD-class resolution may be realized using the deposition mask according to the invention.

The diameter of the through-hole and the pitch between the through-holes may be a size for forming a green sub pixel. The deposition mask may be an OLED deposition mask for realizing ultra-high display pixels.

With reference to FIG. 6, the cross section in the A-A' direction and the cross section in the B-B' direction of FIG. A and FIG. B, are described, respectively.

FIG. 6 is a view showing each cross section overlapped for describing a height step and a size between the cross section in the A-A' direction and the cross section in the B-B' direction of FIG. A and FIG. B.

First, the cross section in the A-A' direction of FIG. A and FIG. B will be described. The A-A' direction is a cross section that crosses the center region between a first through-hole TH1 and a third through-hole TH3 adjacent in the vertical direction. That is, the cross section in the A-A' direction may not include through-holes.

An etching surface ES2 in a large surface hole and an island portion IS which is the other surface of a deposition mask not etched between the etching surfaces ES2 in the large surface hole may be positioned in the cross section in the A-A' direction. Accordingly, the island portion IS may include a surface parallel to one unetched surface of the deposition mask. Alternatively, the island portion IS may include a surface that is the same as or parallel to the other unetched surface of the deposition mask.

Next, the cross section in the B-B' direction of FIG. A and FIG. B will be described. The B-B' direction is a cross section that crosses the center of each of the first through-hole TH1 and the second through-hole TH2 that are adjacent in the horizontal direction. That is, the cross section in the direction B-B' may include a plurality of through-holes.

One rib may be positioned between the third through-hole TH3 and the fourth through-hole TH4 adjacent in the direction B-B'. Another rib may be positioned between the fourth through-hole TH4 and the fifth through-hole adjacent to the fourth through-hole in the horizontal direction but positioned in a direction opposite to third through-hole TH3. One through-hole may be positioned between the one rib and the other rib. That is, one through-hole may be positioned between two ribs adjacent in the horizontal direction.

In the cross section in the B-B' direction, a rib RB which is a region in which the etching surface ES2 in the large surface hole and the etching surfaces ES2 in the adjacent large surface hole are connected to each other, may be positioned. Here, the rib RB may be a region in which a boundary of two adjacent large surface holes is connected. Since the rib RB is an etching surface, the rib RB may have a smaller thickness than the island portion IS.

For example, the island portion may have a width of 2 µm or more. That is, a width in a direction parallel to the other surface of a portion remaining unetched on the other surface may be 2 µm or less. When a width of one end and the other end of one island portion is 2 µm or more, the total volume of the deposition mask may be increased. The deposition mask having such a structure ensures sufficient rigidity against a tensile force applied to an organic material deposition process or the like, and thus it may be advantageous for maintaining uniformity of the through-hole.

With reference to FIG. 8, the cross section of B-B' of FIG. 5 and an enlarged cross section of the through-hole between the rib RB of an effective region according to FIG. 6 and the ribs will be described. In the deposition mask of the invention, a thickness of an effective portion AA in which the through-hole is formed by etching may be different from a thickness of an ineffective portion UA that is not etched. In detail, a thickness of the rib RB may be less than the thickness in the ineffective portion UA that is not etched.

In the deposition mask of the invention, the thickness of the ineffective portion may be greater than that of the effective portion. For example, in the deposition mask of the invention, a maximum thickness of the ineffective portion or a non-deposition region may be 30 µm or less. For example, in the deposition mask of the invention, the maximum thickness of the ineffective portion or the non-deposition region may be 25 µm or less. For example, in the deposition mask of the invention, the maximum thickness of the ineffective portion or the non-deposition region may be 15 µm to 25 µm. When the maximum thickness of the ineffective portion or the non-deposition region of the deposition mask according to the invention is greater than 30 µm, it may be difficult to form through-holes having a fine size because a thickness of a metal plate material is thick. When the maximum thickness of the ineffective portion or the non-deposition region of the deposition mask according to the invention is less than 15 µm, it may be difficult to form through-holes having a uniform size because the thickness of the metal plate material is thin.

A maximum thickness T3 measured at the center of the rib RB may be 15 µm or less. For example, the maximum thickness T3 measured at the center of the rib RB may be 7 µm to 10 µm. For example, the maximum thickness T3 measured at the center of the rib RB may be 6 µm to 9 µm. When the maximum thickness T3 measured at the center of the rib RB is greater than 15 µm, it may be difficult to form an OLED deposition pattern having a high-resolution of 500 PPI or more. When the maximum thickness T3 measured at the center of the rib RB is less than 6 µm, it may be difficult to form uniformly the deposition pattern.

A height H1 of the small surface hole of the deposition mask may be 0.2 to 0.4 times the maximum thickness T3 measured at the center of the rib RB. For example, the maximum thickness T3 measured at the center of the rib RB may be 7 µm to 9 µm, and the height H1 between one surface of the deposition mask and the communication portion may be 1.4 µm to 3 µm. The height H1 of the small surface hole of the deposition mask is 3 µm or less. For example, the height of the small surface hole may be 0.1 µm to 3 µm. For example, the height of the small surface hole of the deposition mask may be 0.5 µm to 3 µm. For example, the height of the small surface hole of the deposition mask may be 1 µm to 3 µm. Here, the height may be measured in a thickness measurement direction of the deposition mask, that is, in a depth direction, and may be a height measured from one surface of the deposition mask to the communication portion. In detail, it may be measured in the z-axis direction forming 90 degrees to the horizontal direction (x direction) and the vertical direction (y direction) described above in the plan view of FIG. 4 or FIG. 5.

When the height between one surface of the deposition mask and the communication portion is greater than 3 µm, deposition failure may occur due to a shadow effect in which a deposition material spreads to a region larger than an area of a through-hole during OLED deposition.

A hole diameter W1 at one surface in which a small surface hole V1 of the deposition mask is formed and a hole diameter W2 at the communication portion which is a boundary between the small surface hole V1 and a large surface hole V2, may be similar to or different from each other. The hole diameter W1 at the one surface on which the small surface hole V1 of the deposition mask is formed may be larger than the hole diameter W2 at the communication portion.

The difference between the hole diameter W1 at one surface of the deposition mask and the hole diameter W2 at the communication portion is 0.01 µm to 1.1 µm. For example, the difference between the hole diameter W1 at one surface of the deposition mask and the hole diameter W2 at the communication portion may be 0.03 µm to 1.1 µm. For example, the difference between the hole diameter W1 at one surface of the deposition mask and the hole diameter W2 at the communication portion may be 0.05 µm to 1.1 µm.

When the difference between the hole diameter W1 at one surface of the deposition mask and the hole diameter W2 at the communication portion is larger than 1.1 µm, deposition failure may occur due to the shadow effect.

As a curvature radius of an inclination of a first inner side surface ES1 in the small surface hole V1 increases, the shadow effect as the deposition material spreads may be reduced. In the deposition mask, an inclination curvature radius R of the small surface hole is 3 µm to 86 µm. For example, the inclination curvature radius R of the small surface hole may be 4.5 µm to 86 µm. For example, the inclination curvature radius R of the small surface hole may be 17 µm to 86 µm. When the inclination curvature radius R of the small surface hole is 3 µm to 86 µm, the deposition material may form a pattern having a uniform shape.

An inclination angle connecting one end E1 of the small surface hole positioned at one surface of the deposition mask and one end E2 of the communication portion between the small surface hole and the large surface hole is 70 degrees to 89 degrees. For example, the inclination angle connecting one end E1 of the small surface hole positioned at the one surface of the deposition mask and one end E2 of the communication portion between the small surface hole and the large surface hole may be 75 degrees to 89 degrees. For example, the inclination angle connecting one end E1 of the small surface hole positioned at the one surface of the deposition mask and one end E2 of the communication portion between the small surface hole and the large surface hole may be 78 degrees to 89 degrees. For example, the inclination angle connecting one end E1 of the small surface hole positioned at the one surface of the deposition mask and one end E2 of the communication portion between the small surface hole and the large surface hole may be 85 degrees to 89 degrees.

When the inclination angle connecting one end E1 of the small surface hole located on one surface of the deposition mask and one end E2 of the communication portion between the small surface hole and the large surface hole exceeds 89 degrees, the shadow effect may be prevented, but a problem that organic matter remains in the through-hole during deposition may occur. Accordingly, it may be difficult to form a deposition pattern of uniform size.

When the inclination angle connecting one end E1 of the small surface hole located on one surface of the deposition mask and one end E2 of the communication portion between the small surface hole and the large surface hole is less than 70 degrees, deposition failure may occur due to the shadow effect.

That is, in the deposition mask according to the invention, the inclination angle θ1 of the small surface hole is 70 degrees to 89 degrees, and a curvature of the small surface hole is formed to be 3 µm to 86 µm, and thus it is possible to prevent the shadow effect, and to solve a problem of organic matter remaining in the deposition mask during a deposition process. In a process of separating the deposition mask from a substrate after the organic matter is deposited on the substrate, it is possible to prevent a problem that the organic matter deposited on the substrate adheres to the deposition mask and is removed.

In addition, a volume of the island portion may be increased to prevent deformation during pulling of the deposition mask.

In the deposition mask capable of realizing a resolution of 500 PPI class, an inclination angle connecting one end E1 of the small surface hole and one end E2 of the communication portion between the small surface hole and the large surface hole may be 75 degrees to 89 degrees, and an inclination curvature radius of the small surface hole may be 4.5 µm to 86 µm.

In the deposition mask capable of realizing a resolution of 600 PPI to 700 PPI class, an inclination angle connecting one end E1 of the small surface hole and one end E2 of the communication portion between the small surface hole and the large surface hole may be 78 degrees to 89 degrees, and an inclination curvature radius of the small surface hole may be 6 µm to 86 µm.

In the deposition mask capable of realizing a resolution of 800 PPI or more, an inclination angle connecting one end E1 of the small surface hole and one end E2 of the communication portion between the small surface hole and the large surface hole may be 85 degrees to 89 degrees, and an inclination curvature radius of the small surface hole may be 17 µm to 86 µm.

An inclination angle connecting one end E3 of the large surface hole V2 positioned on the other surface opposite to the one surface of the deposition mask and one end E2 of the communication portion between the small surface hole and the large surface hole may be 40 to 55 degrees. Accordingly, the deposition pattern having a high-resolution of 500 PPI or more may be formed, and simultaneously, the island portion may exist on the other surface of the deposition mask.

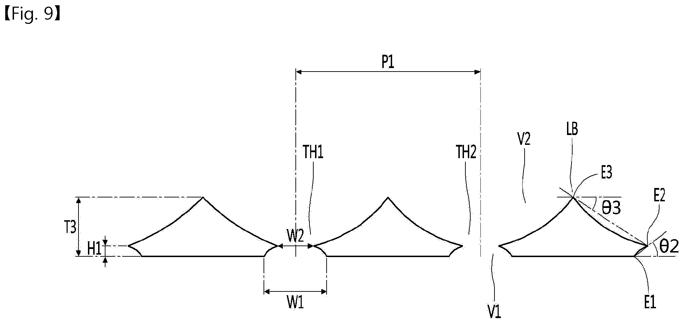

With reference to FIG. 9, a structure of a cross section of a rib portion of the deposition mask according to Comparative Example will be described.

In the deposition mask according to Comparative Example, an inclination angle of a small surface hole measured at a position corresponding to Example may be smaller than that of Example. For example, an inclination angle θ2 of a small hole diameter of the deposition mask according to Comparative Example may be less than 70 degrees.

In the deposition mask according to Comparative Example, a height of the small surface hole measured at a position corresponding to Example may be greater than that of Example. For example, a height of the small hole diameter of the deposition mask according to Comparative Example may exceed 3 µm.

In the deposition mask according to Comparative Example, a difference between a diameter of the small surface hole and a diameter of a through-hole measured at the position corresponding to Example may be greater than that of Example. For example, in the deposition mask according to Comparative Example, a difference between a diameter W1 of the small surface hole and a diameter W2 of the through-hole measured at the position corresponding to Example may exceed 1.1 µm.

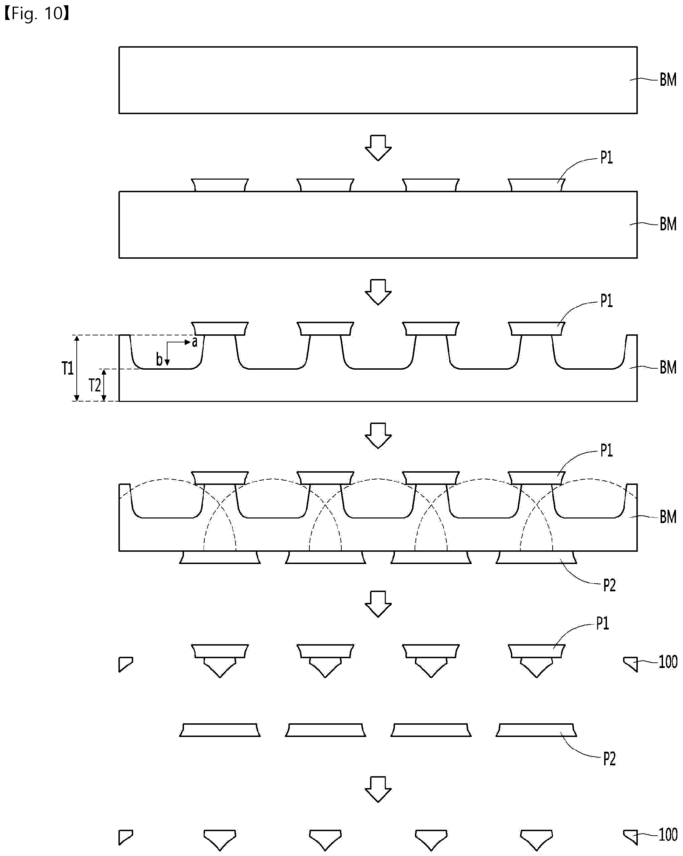

With reference to FIG. 10, a method of manufacturing a deposition mask will be described.

In the method for manufacturing the deposition mask of a metal material for OLED pixel deposition, the deposition mask according to the invention may be manufactured including: a first step of preparing a base metal plate of a thickness of 20 µm to 30 µm; a second step of disposing a patterned photoresist layer on one side of the base metal plate, forming a groove on one surface of the base metal plate by half-etching an open portion of the photoresist layer, disposing a patterned photoresist layer on the other side of the base metal plate opposite the one side, and forming a through-hole connected to the groove on the one surface of the base metal plate by etching the open portion of the photoresist layer; and a third step of removing the photoresist layer to form a deposition mask including a large surface hole formed on the one surface, a small surface hole formed on the other surface opposite to the one surface, and a through-hole formed by a communication portion to which a boundary between the large surface hole and the small surface hole is connected. Through this, it is possible to manufacture a deposition mask that may realize a resolution of 500 PPI or more.

In the method for manufacturing the deposition mask of a metal material for OLED pixel deposition, the deposition mask according to the invention may be manufactured including: a first step of preparing a base metal plate of a thickness of 15 µm to 20 µm; a second step of disposing a patterned photoresist layer on one side of the base metal plate, forming a groove on one surface of the base metal plate by half-etching an open portion of the photoresist layer, disposing a patterned photoresist layer on the other side of the base metal plate opposite the one side, and forming a through-hole connected to the groove on the one surface of the base metal plate by etching the open portion of the photoresist layer; and a third step of removing the photoresist layer to form a deposition mask including a large surface hole formed on the one surface, a small surface hole formed on the other surface opposite to the one surface, and a through-hole formed by a communication portion to which a boundary between the large surface hole and the small surface hole is connected. Through this, it is possible to manufacture a deposition mask that may realize a resolution of 800 PPI or more.

First, the first step of preparing a base metal plate BM having a thickness of 20 µm to 30 µm will be described.

The base metal plate BM may include a metal material. The base metal plate BM may include a nickel alloy. For example, the base metal plate BM may be an alloy of nickel and iron. At this point, the nickel may be about 35 to 37 wt%, and the iron may be about 63 to 65 wt%. For example, the base metal plate BM may include an invar including about 35 to 37 wt% of nickel, about 63 to 65 wt% of iron, and at least one of a trace amount of C, Si, S, P, Cr, Mo, Mn, Ti, Co, Cu, Fe, Ag, Nb, V, In, and Sb. Here, the small amount may mean not more than 1w%. Specifically, here, the trace amount may refer to 0.5 wt% or less. However, the base metal plate BM is not limited thereto, and may obviously include various metal materials.

Since the nickel alloy such as invar has a small thermal expansion coefficient, it has advantage that a lifetime of the deposition mask may be increased.

Here, the first step may further include a thickness reduction step according to a target thickness of the base metal plate.

For example, the base metal plate BM may have a thickness of 25 µm to 30 µm. The base metal sheets BM may have a thickness of 15 µm to 25 µm through the thickness reduction step by rolling and/or etching. Here, the etching may be included electrical or chemical etching.

The base metal plate BM or the base metal plate BM that has undergone a thickness reduction step may optionally include a surface treatment step.

For example, there is a problem that uniform etching for the nickel alloy such as the invar is difficult. That is, in the nickel alloy such as the invar, the etch rate may be increased in an initial stage of the etching. Accordingly, there is a problem that the etching factor of the small surface hole may be lowered. When the etching factor of the small surface hole is lowered, there may be a problem that a deposition mask may be formed in which deposition failure occurs due to the shadow effect. Alternatively, de-filming of the photoresist layer may occur due to side etching of the large surface hole. In addition, it may be difficult to form a through-hole having a fine size as a size of the through-hole increases. Further, the through-hole is formed non-uniformly, so that a yield of the deposition mask may be lowered

Therefore, in an embodiment, a surface layer for surface modification may be disposed on a surface of the base metal plate with different composition, content, crystal structure and corrosion rate. Here, the surface modification may mean a layer made of various materials disposed on the surface to improve an etching factor.

That is, a surface treatment layer may be a layer for preventing rapid etching on the surface of the base metal plate. The surface treatment layer may be an etching barrier layer having a lower etch rate than that of the base metal plate. The surface treatment layer may have a different crystal plane and crystal structure from those of the base metal layer. For example, as the surface treatment layer includes a different element from that of the base metal layer, a crystal plane and a crystal structure may be different from each other.

In the same corrosion environment, the surface treatment layer may have a different corrosion potential from that of the base metal plate. For example, when the same etchant is applied for the same time at the same temperature, the surface treatment layer may have different corrosion currents or corrosion potentials from those of the base metal plate.

The base metal plate BM may include a surface treatment layer or a surface treatment portion on one surface and/or both surfaces, the entire surface, and/or an effective region thereof. The surface treatment layer or the surface treatment portion may include different elements from the base metal plate, or may include a metal element having a slow corrosion rate in a larger content than the base metal plate.

For example, the surface treatment layer may include at least one metal of nickel (Ni), chromium (Cr), iron (Fe), titanium (Ti), manganese (Mn), oxygen (O), molybdenum (Mo), silver (Ag), zinc (Zn), nitrogen (N), aluminum (Al) and alloys thereof, and a content of at least one metal of nickel (Ni), chromium (Cr), iron (Fe), titanium (Ti), manganese (Mn), oxygen (O), molybdenum (Mo), silver (Ag), zinc (Zn), nitrogen (N), aluminum (Al) and alloys thereof may be greater than that of the base metal plate.

In case of further including such a surface treatment step, the surface treatment layer may be disposed on a surface of the base metal plate according to the embodiment. In the surface treatment step, the surface treatment layer of the element different from the base metal plate BM is disposed, so that the corrosion rate on the surface may be slower than that of a raw material of the base metal plate BM. Accordingly, the etching factor of the deposition mask according to the embodiment may be increased. In addition, since the deposition mask according to the invention may uniformly form a plurality of through-holes, the deposition efficiency of R, G, and B patterns may be improved. Here, including different elements may mean that the base metal plate BM and the surface treatment layer include at least one different element, or even though all the elements are the same, alloys having different contents are included.

Next, a disposing step of a patterned photoresist layer P1 on one surface of the base metal plate will be described. The patterned photoresist layer P1 may be disposed on one surface of the base metal plate in order to form a small surface hole. An etching barrier layer such as a coating layer or a film layer for preventing etching may be disposed on the other surface opposite to one surface of the base metal plate.

Next, the second step of forming a groove on one surface of the metal plate by half-etching an open portion of the photoresist layer P1 will be described.

The open portion of the photoresist layer P1 may be exposed to an etchant or the like, and thus etching may occur in an open portion of one surface of the base metal plate on which the photoresist layer P1 is not disposed.

The second step may be a step of etching the base metal plate having a thickness T1 of about 20 µm to about 30 µm to a thickness of about 1/2. A depth of the groove formed by the second step may be about 10 µm to 15 µm. That is, a thickness T2 of the base metal plate measured at the center of the groove after the second step may be about 10 µm to 15 µm.

The second step may be an anisotropic etching or semi additive process (SAP). In detail, the anisotropic etching or semi additive process may be used to half-etch the open portion of the photoresist layer. Accordingly, in the groove formed by the half-etching, an etch rate (b direction) in a depth direction may be faster than that of the side etching (a direction) than an isotropic etching.

An etching factor of the small surface hole may be 2.0 to 3.0. For example, the etching factor of the small surface hole may be 2.1 to 3.0. For example, the etching factor of the small surface hole may be 2.2 to 3.0.

Here, the etching factor may mean that a depth B of an etched small surface hole divided by a width A of the photoresist layer extending from the island portion on the small surface hole and protruding toward the center of the through-hole (Etching Factor = B/A). The A may mean an average value of a width of one side of the photoresist layer protruding on the one surface hole and a width of the other side opposite to the one side.

Next, a forming step of the through-hole will be described.

First, a patterned photoresist layer P2 may be disposed on the other surface opposite to the one surface of the base metal plate. The patterned photoresist layer P2 having an open portion may be disposed on the other surface opposite to the one surface of the base metal plate in order to form a large surface hole. An etching barrier layer such as a coating layer or a film layer for preventing etching may be disposed on one surface of the base metal plate.

The open portion of the photoresist layer P2 may be exposed to an etchant, and thus etching may occur in an open portion of the other surface of the base metal plate on which the photoresist layer P2 is not disposed. The other surface of the base metal plate may be etched by anisotropic etching or isotropic etching.

The open portion of the photoresist layer is etched, and thus the groove on one surface of the metal plate may be connected to the large surface hole to form a through-hole.

In the second step, 1) the patterned photoresist layer P1 is disposed on one surface of the base metal plate and the patterned photoresist layer P2 is disposed on the other surface of the base metal plate. And then, 2) the through-hole may be formed by etching one surface and the other surface of the base metal plate at the same.

Alternatively, in the second step, 1) the patterned photoresist layer P1 may be disposed on one surface of the base metal plate, and 2) the grove may be formed on only one surface of the base metal plate by half-etching the open portion of the photoresist layer P1. Then, 3) the patterned photoresist layer P2 may be disposed on the other surface of the base metal plate. And then 4) the through-hole may be formed on the other surface of the base metal plate by etching the open portion of the photoresist layer P2.

Alternatively, in the second step, 1) the patterned photoresist layer P2 may be disposed on the other surface of the base metal plate, and 2) the large surface hole may be formed on only the other surface of the base metal plate by etching the open portion of the photoresist layer P2. Then, 3) the patterned photoresist layer P1 may be disposed on the one surface of the base metal plate. And then 4) the through-hole connected to the large surface hole may be formed on the one surface of the base metal plate by half-etching the open portion of the photoresist layer P1.

Next, the photoresist layer is removed, and the deposition mask may be formed through the third step of forming the deposition mask including the large surface hole formed on the one surface, the small surface hole formed on the other surface opposite to the one surface, and the through-hole formed by the communication portion to which the boundary between the large surface hole and the small surface hole is connected.

A deposition mask 100 formed through the third step may include the same material as the base metal plate. For example, the deposition mask may include a material having the same composition as the base metal plate. For example, the island portion of the deposition mask may include the surface treatment layer described above.

In the deposition mask formed through the third step, a maximum thickness at the center of the rib may be smaller than a maximum thickness at an ineffective region not subjected to etching. For example, the maximum thickness at the center of the rib may be 15 µm. For example, the maximum thickness at the center of the rib may be less than 10 µm. However, a maximum thickness in an ineffective region of the deposition mask may be 20 µm to 30 µm. The maximum thickness in the ineffective region of the deposition mask may be equal to a thickness of the base metal plate prepared in the first step. Alternatively, the maximum thickness in the ineffective region of the deposition mask may be 15 µm to 25 µm after a thickness reduction step in the first step.

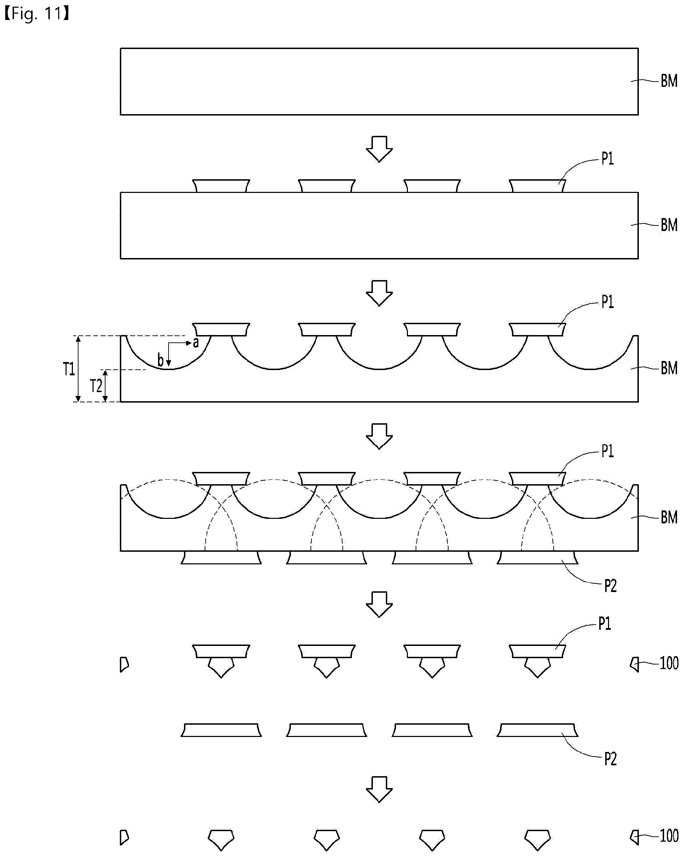

With reference to FIG. 11, a method of manufacturing a deposition mask according to Comparative Example will be described.

Referring to FIG. 11, a base metal plate BM including the same thickness and the same material as that of Example may be prepared.

Next, a photoresist layer P1 may be disposed on one surface of the deposition mask according to Comparative Example.

Thereafter, a half-etched groove portion of the deposition mask according to Comparative Example may be formed by an isotropic etching. That is, an etching factor of a small surface hole formed by the isotropic etching of Comparative Example may be smaller than that of a small surface hole formed by an anisotropic etching or semi-additive process of Example. As an example, the etching factor of the small surface hole formed by the isotropic etching may be 1.5 to 2.5. As an example, the etching factor of the small surface hole formed by the isotropic etching may be 1.5 to 2.1.

That is, in case of the isotropic etching according to Comparative Example, a speed of the side etching (a direction) may be faster than that of Example.

Next, in the deposition mask according to Comparative Example, after a photoresist layer P2 is disposed on the other surface opposite to one surface, the deposition mask may be formed by etching.

In the deposition mask according to Comparative Example, a height H1 between one surface of the deposition mask on which a small surface hole is formed and the communication portion may exceed 3 µm.

In the deposition mask according to Comparative Example, a deviation between a hole diameter W1 at one surface in which the small surface hole of the deposition mask is formed and a hole diameter W2 at the communication portion may exceed 1.1 µm.

Accordingly, in an OLED pattern formed through the deposition mask according to Comparative Example, deposition failure may occur due to a shadow effect.

Hereinafter, the present invention will be described in more detail with reference to Examples and Comparative Examples. Such Examples are merely illustrative for describing the present invention in more detail. Therefore, the present invention is not limited to thereto.

### <Experimental Example 1: Measuring of W1-W2 value, Small hole diameter curvature, Small hole diameter inclination angle >

When a height H1 between one surface of a deposition mask having a small surface hole formed thereon and a communicating portion is 3 µm, Table 1 shows an evaluation result of measuring a deviation between a hole diameter W1 at one surface on which the small surface hole is formed and a diameter W2 at a communicating portion, a curvature of a small hole diameter, and an inclination angle of the small hole diameter.

**[Table 1]**

| | W1-W2 value (µm) | Small hole diameter curvature (R) value (µm) | Small hole diameter inclination angle value (01) |
|---|---|---|---|
| Example 1 | 1.091 | 4.667 | 70° |
| Example 2 | 0.084 | 6.0 | 75° |
| Example 3 | 0.262 | 17.276 | 85° |
| Example 4 | 0.052 | 85.961 | 89° |

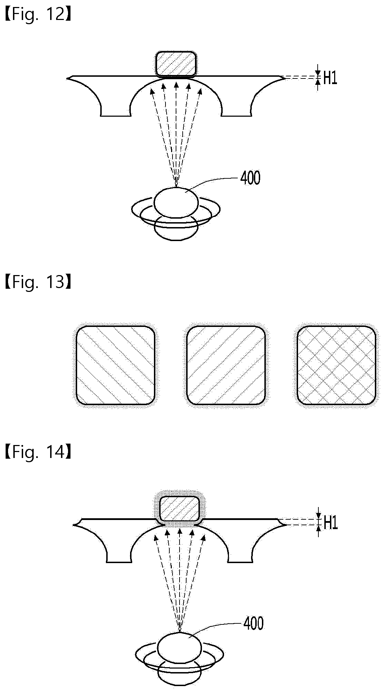

A shadow effect of Example and Comparative Example will be described with reference to FIGS. 12 to 15, and a difference between inclined angles of small surface holes according to Example and Comparative Example will be described with reference to FIGS. 8 and 9.

With reference to FIGS.12 and 13, a deposition pattern formed through a deposition mask according to Example will be described.

Referring to FIG. 12, in the deposition mask according to Example, a height H1 between one surface of the deposition mask in which the small surface hole is formed and the communication portion is 3 µm or less. Accordingly, a distance between one surface of the deposition mask and a substrate on which a deposition pattern is disposed may be short, and thus deposition failure due to a shadow effect may be reduced.

Referring to FIG. 13, deposition failure in which different deposition materials are placed in the same region may not occur in a region between two adjacent patterns among adjacent R, G, and B patterns. That is, the R, G, and B patterns according to Example may minimize a shadow phenomenon in which a deposition material spreads around the pattern. Therefore, in the deposition mask according to Example, a height of a small hole diameter is 3 µm or less, thereby preventing OLED pixel deposition failure.

In addition, referring to FIG. 7, the inclination angle θ1 of the small hole diameter of the deposition mask according to Example is 70 degrees to 89 degrees. Accordingly, the deposition mask according to Example may minimize the deposition failure due to the shadow effect.

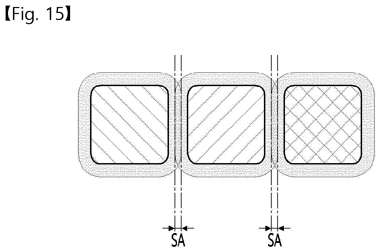

With reference to FIGS.14 and 15, a deposition pattern formed through a deposition mask according to Comparative Example will be described.

Referring to FIG. 14, in the deposition mask according to Comparative Example, a height H1 between one surface of the deposition mask in which the small surface hole is formed and the communication portion may exceed 3 µm. Accordingly, since a distance between one surface of the deposition mask and a substrate on which a deposition pattern is disposed may be farther than that of Example, deposition failure due to a shadow effect may be increased.

Referring to FIG. 15, deposition failure in which different deposition materials are placed in the same region may occur in a region between two adjacent patterns among adjacent R, G, and B patterns. That is, in the R, G, and B patterns according to Comparative Example, a shadow phenomenon in which a deposition material spreads around the pattern may occur. For example, in Comparative Example, as the deposition material spreads between the R pattern and the G pattern, an overlapping region SA in which the R pattern forming material and the G pattern forming material occupy the same region of the substrate may occur. Therefore, a structure of the deposition mask according to Comparative Example may prevent OLED pixel deposition failure.

In addition, referring to FIG. 9, the inclination angle θ2 of the small hole diameter of the deposition mask according to Comparative Example may be less than 70 degrees. Accordingly, the deposition mask according to Comparative Example, the deposition failure due to the shadow effect may occur.

## Claims

1. A metal mask for deposition, the metal mask comprising,
a deposition region and a non-deposition region,
wherein the deposition region includes an effective portion and an ineffective portion,
wherein the effective portion includes a plurality of through-holes, wherein the through-holes include:
a small surface hole formed on one surface,
a large surface hole formed on the other surface opposite to the one surface; and
a communication portion in where an inner surface of the small surface hole meets an inner surface of the large surface hole;
wherein an island portion is formed between the plurality of large surface holes;
wherein a height from the communication portion to the one surface is 3 µm or less,
wherein the small surface hole has a hole diameter (W1),
wherein through-hole has a diameter (W2) at the communication portion,
wherein the hole diameter (W1) is greater than the diameter (W2) of the through-hole,
wherein a difference between the hole diameter (W1) and the diameter (W2) of the through-hole is 0.01 µm to 1.1 µm,
wherein an inclination angle (θ1) connecting one end of the small surface hole with respect to the one surface and one end of the communication portion is 70 degrees to 89 degrees, and
wherein an inclination curvature radius of an inner surface of the small surface hole with respect to the one surface is 3 µm to 86 µm.

2. The metal mask of claim 1, wherein an inclination angle (θ1) connecting one end of the small surface hole with respect to the one surface and one end of the communication portion is 85 degrees to 89 degrees.

3. The metal mask of any one of claims 1 to 2, wherein the diameter (W2) of the through-hole at the communication portion is 33 µm or less.

4. The metal mask of claim 3, wherein the deposition mask has a resolution of 500 PPI or more in which a distance (P1) between centers a plurality of through holes adjacent in the horizontal direction is 48 µm or less.

5. The metal mask of any one of claims 1 to 2,
wherein the diameter (W2) of the through-hole is defined in the horizontal direction on the communication portion, and the diameter (W2) of the through-hole is 20 µm or less, and
wherein the deposition mask has a resolution of 800 PPI or more in which a distance (P1) between centers a plurality of through holes adjacent in the horizontal direction is 32 µm or less.

6. The metal mask of any one of claims 1 to 2, wherein an average deviation of the diameter (W2) of each of the plurality of through-holes at the communication portion is 2% to 10%.

7. The metal mask of claim 6, wherein the average deviation of the diameter (W2) of each of the plurality of through-holes is ± 3 µm.

8. The metal mask of claim 4, wherein the distance (P1) between centers the plurality of through holes adjacent in the horizontal direction is 20 µm to 48 µm .

9. The metal mask of claim 3, wherein the diameter (W2) of the through-hole at the communication portion is 15 µm to 33 µm.

10. The metal mask of claims 1 to 2, wherein a height (H1) from the communication portion to the one surface is 0.1 µm to 3 µm or less.

11. The metal mask of any one of claims 1 to 2, wherein a difference between the hole diameter (W1) and the diameter (W2) of the through-hole is 0.05 µm to 1.1 µm.

## Patentansprüche

1. Metallmaske zum Ablagern, die Metallmaske umfassend,
eine Ablagerungsregion und eine Nichtablagerungsregion,
wobei die Ablagerungsregion einen wirksamen Abschnitt und einen unwirksamen Abschnitt einschließt,
wobei der wirksame Abschnitt eine Vielzahl von Durchgangslöchern einschließt, wobei die Durchgangslöcher Folgendes einschließen:
Ein kleines Oberflächenloch, das sich auf einer Oberfläche gebildet hat,
ein großes Oberflächenloch, das auf der anderen Oberfläche gegenüber der einen Oberfläche ausgebildet ist; und
einen Kommunikationsabschnitt, in dem eine innere Oberfläche des kleinen Oberflächenlochs auf eine innere Oberfläche des großen Oberflächenlochs trifft;
wobei ein Inselabschnitt zwischen der Vielzahl der großen Oberflächenlöcher gebildet wird;
wobei eine Höhe von dem Kommunikationsabschnitt zu der einen Oberfläche 3 µm oder weniger beträgt,
wobei das kleine Oberflächenloch einen Lochdurchmesser (W1) aufweist,
wobei die Durchgangsbohrung am Kommunikationsabschnitt einen Durchmesser (W2) aufweist,
wobei der Lochdurchmesser (W1) größer ist als der Durchmesser (W2) des Durchgangslochs,
wobei ein Unterschied zwischen dem Lochdurchmesser (W1) und dem Durchmesser (W2) des Durchgangslochs 0,01 µm bis 1,1 µm beträgt,
wobei ein Neigungswinkel (01), der ein Ende des kleinen Oberflächenlochs in Bezug auf die eine Oberfläche und ein Ende des Kommunikationsabschnitts verbindet, 70 Grad bis 89 Grad beträgt, und
wobei ein Neigungskrümmungsradius einer inneren Oberfläche des kleinen Oberflächenlochs in Bezug auf die eine Oberfläche 3 µm bis 86 µm beträgt.

2. Metallmaske nach Anspruch 1,
wobei ein Neigungswinkel (01), der ein Ende des kleinen Oberflächenlochs in Bezug auf die eine Oberfläche und ein Ende des Kommunikationsabschnitts verbindet, 85 Grad bis 89 Grad beträgt.

3. Metallmaske nach einem der Ansprüche 1 bis 2, wobei der Durchmesser (W2) des Durchgangslochs am Kommunikationsabschnitt 33 µm oder weniger beträgt.

4. Metallmaske nach Anspruch 3,
wobei die Ablagerungsmaske eine Auflösung von 500 PPI oder mehr aufweist, in der ein Abstand (P1) zwischen den Zentren einer Vielzahl von in horizontaler Richtung benachbarten Durchgangslöchern 48 µm oder weniger beträgt.

5. Metallmaske nach einem der Ansprüche 1 bis 2,
wobei der Durchmesser (W2) des Durchgangslochs in der horizontalen Richtung auf dem Kommunikationsabschnitt definiert ist, und der Durchmesser (W2) des Durchgangslochs 20 µm oder weniger beträgt, und
wobei die Ablagerungsmaske eine Auflösung von 800 PPI oder mehr aufweist, in der ein Abstand (P1) zwischen den Zentren einer Vielzahl von in horizontaler Richtung benachbarten Durchgangslöchern 32 µm oder weniger beträgt.

6. Metallmaske nach einem der Ansprüche 1 bis 2,
wobei eine durchschnittliche Abweichung des Durchmessers (W2) von jedem der Vielzahl von Durchgangslöchern am Kommunikationsabschnitt 2 % bis 10 % beträgt.

7. Metallmaske nach Anspruch 6,
wobei die durchschnittliche Abweichung des Durchmessers (W2) jeder der Vielzahl von Durchgangslöchern ± 3 µm beträgt.

8. Metallmaske nach Anspruch 4,
wobei der Abstand (P1) zwischen den Zentren der Vielzahl von in horizontaler Richtung benachbarten Durchgangslöchern 20 µm bis 48 µm beträgt.

9. Metallmaske nach Anspruch 3,
wobei der Durchmesser (W2) des Durchgangslochs am Kommunikationsabschnitt 15 µm bis 33 µm beträgt.

10. Metallmaske nach einem der Ansprüche 1 bis 2,
wobei eine Höhe (H1) von dem Kommunikationsabschnitt zu der einen Oberfläche 0,1 µm bis 3 µm oder weniger beträgt.

11. Metallmaske nach einem der Ansprüche 1 bis 2,
wobei ein Unterschied zwischen dem Lochdurchmesser (W1) und dem Durchmesser (W2) des Durchgangslochs 0,05 µm bis 1,1 µm beträgt.

## Revendications

1. Masque métallique pour dépôt, le masque métallique comprenant une zone de dépôt et une zone de non-dépôt,
dans lequel la zone de dépôt comporte une partie efficace et une partie non efficace,
dans lequel la partie efficace comporte une pluralité de trous débouchants, dans lequel les trous débouchants comportent :
un trou de petite surface formé sur une surface,
un trou de grande surface formé sur l'autre surface opposée à la une surface ; et
une partie de communication dans laquelle une surface intérieure du trou de petite surface rejoint une surface intérieure du trou de grande surface ;
dans lequel une partie d'îlot est formée entre la pluralité de trous de grande surface ;
dans lequel une hauteur à partir de la partie de communication vers la une surface est inférieure ou égale à 3 µm,
dans lequel le trou de petite surface présente un diamètre de trou (W1),
dans lequel le trou débouchant présente un diamètre (W2) au niveau de la partie de communication,
dans lequel le diamètre de trou (W1) est supérieur au diamètre (W2) du trou débouchant,
dans lequel une différence entre le diamètre de trou (W1) et le diamètre (W2) du trou débouchant est 0,01 µm à 1,1 µm,
dans lequel un angle d'inclinaison (θ1) reliant une extrémité du trou de petite surface par rapport à la une surface et une extrémité de la partie de communication est 70 degrés à 89 degrés, et
dans lequel un rayon de courbure d'inclinaison d'une surface intérieure du trou de petite surface par rapport à la une surface est 3 µm à 86 µm.

2. Masque métallique selon la revendication 1,
dans lequel un angle d'inclinaison (θ1) reliant une extrémité du trou de petite surface par rapport à la une surface et une extrémité de la partie de communication est 85 degrés à 89 degrés.

3. Masque métallique selon l'une quelconque des revendications 1 à 2,
dans lequel le diamètre (W2) du trou débouchant au niveau de la partie de communication est inférieur ou égal à 33 µm.

4. Masque métallique selon la revendication 3,
dans lequel le masque de dépôt présente une résolution supérieure ou égale à 500 PPI ou plus dans laquelle une distance (P1) entre les centres d'une pluralité de trous débouchants adjacents dans la direction horizontale est inférieure ou égale à 48 µm.

5. Masque métallique selon l'une quelconque des revendications 1 à 2,
dans lequel le diamètre (W2) du trou débouchant est défini dans la direction horizontale sur la partie de communication, et le diamètre (W2) du trou débouchant est inférieur ou égal à 20 µm, et
dans lequel le masque de dépôt présente une résolution supérieure ou égale à 800 PPI ou plus dans laquelle une distance (P1) entre les centres d'une pluralité de trous débouchants adjacents dans la direction horizontale est inférieure ou égale à 32 µm.

6. Masque métallique selon l'une quelconque des revendications 1 à 2,
dans lequel un écart moyen du diamètre (W2) de chacun de la pluralité de trous débouchants au niveau de la partie de communication est 2 % à 10 %.

7. Masque métallique selon la revendication 6,
dans lequel l'écart moyen du diamètre (W2) de chacun de la pluralité de trous débouchants est ± 3 µm.

8. Masque métallique selon la revendication 4,
dans lequel la distance (P1) entre les centres de la pluralité de trous débouchants adjacents dans la direction horizontale est 20 µm à 48 µm.

9. Masque métallique selon la revendication 3,
dans lequel le diamètre (W2) du trou débouchant au niveau de la partie de communication est 15 µm à 33 µm.

10. Masque métallique selon les revendications 1 à 2,
dans lequel une hauteur (H1) à partir de la partie de communication vers la une surface est inférieure ou égale à 0,1 µm à 3 µm.

11. Masque métallique selon l'une quelconque des revendications 1 à 2,
dans lequel une différence entre le diamètre de trou (W1) et le diamètre (W2) du trou débouchant est 0,05 µm à 1,1 µm.
